# FASCICULE DE BREVET EUROPEEN

(11) **EP 3 281 244 B1**
(45) Date de publication et mention de la délivrance du brevet: **20.08.2025**
(21) Numéro de dépôt: 16715528.2
(22) Date de dépôt: 08.04.2016
(51) Int. Cl.: H01M 4/134, C30B 29/06, C30B 29/60, H01M 4/1395, H01M 4/36, H01M 4/38, H01M 4/62, C01B 33/02, C30B 7/10, C30B 7/14, C30B 29/08, H01G 11/24, H01G 11/36, H01G 11/86, H01M 10/052

(54) **PROCEDE DE FABRICATION D'UN PRODUIT A NANOELEMENTS**
VERFAHREN ZUR HERSTELLUNG EINES MATERIALS MIT NANOELEMENTEN
METHOD FOR MANUFACTURING A MATERIAL HAVING NANOELEMENTS

(30) Priorité: 10.04.2015 FR 1553108
(43) Date de publication de la demande: 14.02.2018
(73) Titulaire: Commissariat à l'Energie Atomique et aux Energies Alternatives, 75015 Paris (FR)
(72) Inventeur: BURCHAK, Olga, 38240 Meylan (FR)
(74) Mandataire: Novaimo
(86) Numéro de dépôt international: PCT/EP2016/057850
(87) Numéro de publication internationale: WO 2016/162540

(56) Documents cités:
- WO-A2-2013/016339
- WO-A2-2013/016339
- US-A1- 2010 297 502
- US-A1- 2010 297 502
- ZIYANG LU ET AL: "In situ growth of Si nanowires on graphene sheets for Li-ion storage", ELECTROCHIMICA ACTA, ELSEVIER SCIENCE PUBLISHERS, BARKING, GB, vol. 74, 14 April 2012 (2012-04-14), pages 176 - 181, XP028509152, ISSN: 0013-4686, [retrieved on 20120420], DOI: 10.1016/J.ELECTACTA.2012.04.046
- TIMOTHY D. BOGART ET AL: "Lithium Ion Battery Peformance of Silicon Nanowires with Carbon Skin", ACS NANO, vol. 8, no. 1, 6 December 2013 (2013-12-06), US, pages 915 - 922, XP055253331, ISSN: 1936-0851, DOI: 10.1021/nn405710w
- XIN SU ET AL: "Silicon-Based Nanomaterials for Lithium-Ion Batteries: A Review", ADVANCED ENERGY MATERIALS, vol. 4, no. 1, 6 December 2013 (2013-12-06), pages n/a - n/a, XP055159251, ISSN: 1614-6832, DOI: 10.1002/aenm.201300882
- CANDACE K. CHAN ET AL: "Solution-Grown Silicon Nanowires for Lithium-Ion Battery Anodes", ACS NANO, vol. 4, no. 3, 23 March 2010 (2010-03-23), pages 1443 - 1450, XP055120894, ISSN: 1936-0851, DOI: 10.1021/nn901409q
- ANDREW T. HEITSCH ET AL: "Solution-Liquid-Solid (SLS) Growth of Silicon Nanowires", JOURNAL OF THE AMERICAN CHEMICAL SOCIETY, vol. 130, no. 16, 1 April 2008 (2008-04-01), pages 5436 - 5437, XP055037876, ISSN: 0002-7863, DOI: 10.1021/ja8011353
- ZIYANG LU ET AL: "In situ growth of Si nanowires on graphene sheets for Li-ion storage", ELECTROCHIMICA ACTA, ELSEVIER SCIENCE PUBLISHERS, BARKING, GB, vol. 74, 14 April 2012 (2012-04-14), pages 176 - 181, XP028509152, ISSN: 0013-4686, [retrieved on 20120420], DOI: 10.1016/J.ELECTACTA.2012.04.046
- TIMOTHY D. BOGART ET AL: "Lithium Ion Battery Peformance of Silicon Nanowires with Carbon Skin", ACS NANO, vol. 8, no. 1, 6 December 2013 (2013-12-06), US, pages 915 - 922, XP055253331, ISSN: 1936-0851, DOI: 10.1021/nn405710w
- XIN SU ET AL: "Silicon-Based Nanomaterials for Lithium-Ion Batteries: A Review", ADVANCED ENERGY MATERIALS, vol. 4, no. 1, 6 December 2013 (2013-12-06), pages n/a - n/a, XP055159251, ISSN: 1614-6832, DOI: 10.1002/aenm.201300882

## Description

### Domaine technique de l'invention

L'invention concerne le domaine de l'énergie, et plus particulièrement des éléments de stockage d'énergie.

L'invention a pour objet plus particulièrement un procédé de fabrication d'un produit comprenant des nanoéléments.

### État de la technique

Les batteries ou supercondensateurs destinés à stocker de l'énergie sont tributaires des capacités de leurs électrodes.

Selon un exemple, les batteries lithium-ion constituent une source d'énergie de choix pour un grand nombre d'applications allant des dispositifs électroniques aux véhicules électriques. La technologie des batteries lithium-ion est une des technologies de stockage de l'énergie les plus prometteuses grâce à une densité d'énergie stockée élevée et une durée de vie en cyclage longue. Cependant, la généralisation des véhicules électriques et des applications de stockage d'énergie à grande échelle exigent des batteries de technologie plus avancée, offrant une densité d'énergie significativement plus élevée que celle offerte par la technologie de batterie lithium-ion actuellement disponible.

A ce jour, la technologie la plus courante de batterie lithium-ion est basée sur l'utilisation d'une cathode en multicouches de LiCoO₂ et d'une anode de graphite, avec des capacités limite théoriques de 137mAh/g pour LiCoO₂ et de 372mAh/g pour le graphite. Les anodes des batteries lithium-ion sont constituées d'une couche de poudre de carbone sous forme graphite, maintenue par un liant. La poudre de carbone forme un milieu poreux conducteur dans lequel pénètre l'électrolyte contenant les ions lithium. Pendant la décharge, les ions lithium s'intercalent dans le carbone à un taux relativement faible.

En ce sens, pour améliorer la capacité des batteries lithium-ion, de nouveaux matériaux d'anode doivent être développés.

Parmi les matériaux d'intérêt possible pour l'anode des batteries lithium-ion, le silicium a fait l'objet d'une grande attention car il présente la capacité théorique de stockage la plus élevée connue (4200 mAh/g pour la phase intercalée Li₂₂Si₅, 3580 mAh/g pour Li₁₅Si₄), et qu'il s'agit d'un matériau abondant et partout disponible. En théorie, les anodes de silicium peuvent augmenter la capacité de charge des batteries lithium-ion actuelles de plus de 30%, et peuvent permettre un gain d'un facteur 10 en association avec les matériaux de cathode de la prochaine génération. La limitation principale du silicium en batterie lithium-ion est l'énorme changement de volume que subit le matériau durant le cyclage et qui conduit à la défaillance de l'électrode. Pour parer à cette limitation mécanique, de nombreux travaux se sont penchés sur la nanostructuration du silicium. Le silicium à l'échelle nanométrique tolère en effet les changements de volume induits par l'intercalation du lithium, et les nanofils de silicium sont particulièrement intéressants à cet égard car ils fournissent à la fois de courtes distances de diffusion du lithium grâce à leurs petits diamètres (<100nm), de longs chemins continus pour le transport du courant et une grande interface de contact avec l'électrolyte.

En ce sens, le document « Lithium Ion Battery Peformance of Silicon Nanowires with Carbon Skin » de Timothy D. Bogart et al. publié dans ACSNANO volume 8, n°1 pages 915-922 en 2014 s'est intéressé à la fabrication de nanofils sous la forme d'une poudre nanométrique de nanofils recouverts de carbone et destinée à la formation d'une anode de batterie lithium-ion. Il a été démontré par ce document que les anodes formées à partir de cette poudre pouvaient atteindre une capacité de l'ordre de 2000mAh/g sur 100 cycles. L'inconvénient majeur qui met en péril l'application industrielle de cette méthode est la complexité du procédé SFLS (acronyme anglais de la méthode « Supercritical fluid - liquid - solid ») utilisé pour la formation de la poudre, très consommateur d'énergie et dangereux à cause des hautes pressions mises en jeu (100atm). Par ailleurs, ce procédé ne permet pas le dopage des nanofils de silicium in situ, la formation d'une « peau » en carbone sur les nanofils a été proposée pour pallier à ce problème, mais cette étape réalisée à haute température alourdit le coût énergétique global de la synthèse de la poudre.

Alternativement, on connait pour la fabrication d'électrodes pour supercapacité la possibilité de réaliser la croissance de nanofils sur une matrice de graphène comme décrit dans le document « Semiconductor nanowires directly grown on graphene-towards wafer scale transferable nanowire arrays with improved electrical contact » de John P. Alper et al. publié dans Nanoscale, 2013, 5, 4114-4118. Cependant, cette technique requiert de nombreuses étapes, rendant ainsi l'industrialisation coûteuse.

En ce sens, il résulte un besoin d'obtenir des nanofils, notamment destinés à former une électrode de batterie, ou de supercondensateur, dont l'industrialisation serait plus aisée.

### Objet de l'invention

Le but de la présente invention est de proposer une solution qui remédie aux inconvénients listés ci-dessus.

On tend vers ce but notamment grâce à un procédé de fabrication d'un produit comprenant des nanoéléments, selon les revendications annexées.

En particulier, l'étape de traitement thermique appliquée au mélange peut être réalisée à une température comprise entre 270°C et 600°C, et préférentiellement comprise entre 270°C et 450°C, sous atmosphère non oxydante.

Le procédé peut comprendre, au préalable de l'étape de formation du mélange, une étape de fourniture de la pluralité de grains électriquement conducteurs associés au catalyseur destiné à la croissance des nanoéléments.

Notamment, l'étape de fourniture de la pluralité de grains électriquement conducteurs peut être telle que le catalyseur comporte une pluralité d'éléments catalyseurs, et au moins un grain de la pluralité de grains électriquement conducteurs comprend une surface sur laquelle au moins un des éléments catalyseurs de la pluralité d'éléments catalyseurs est fixé, avantageusement 50% des grains de la pluralité de grains sont décorés par au moins un élément catalyseur.

Notamment, l'étape d'obtention dudit produit peut comporter une étape de formation d'un produit intermédiaire comportant des grains électriquement conducteurs, à partir desquels s'étendent lesdits nanoéléments, et une matrice enrobant au moins en partie les grains électriquement conducteurs et lesdits nanoéléments.

En particulier, l'étape d'obtention du produit peut comporter une étape de retrait de la matrice du produit intermédiaire mise en œuvre par une étape de lavage du produit intermédiaire.

L'étape d'obtention du produit peut comporter, après l'étape de retrait de la matrice, une étape de dépôt d'une couche électriquement conductrice sur lesdits nanoéléments ou une étape de dopage électrique desdits nanoéléments.

Selon une réalisation, l'étape d'obtention du produit comporte une étape de chauffage du produit intermédiaire permettant la formation, à partir de la matrice, d'un revêtement électriquement conducteur sur lesdits nanoéléments. Notamment, l'étape de chauffage du produit intermédiaire est mise en œuvre par une étape de traitement thermique additionnel dudit produit intermédiaire à une température comprise entre 600°C et 1500°C, de préférence ladite température est comprise entre 900°C et 1000°C.

Préférentiellement, l'étape d'obtention du produit est telle qu'au terme de ladite étape d'obtention, ledit produit obtenu se présente sous la forme d'une poudre munie de grains électriquement conducteurs à partir desquels s'étendent les nanoéléments.

Selon une réalisation, le procédé comporte une étape de réalisation de la pluralité de grains électriquement conducteurs associés au catalyseur comprenant les étapes suivantes :
- un placement des grains de la pluralité de grains et du catalyseur dans un solvant,
- un séchage permettant d'évaporer le solvant d'où il résulte l'association du catalyseur avec lesdits grains de la pluralité de grains électriquement conducteurs.

Le matériau destiné à former les nanoéléments peut être choisi de telle sorte que ledit matériau comporte du silicium, du germanium ou un alliage du silicium avec l'un des matériaux choisis parmi : le germanium, l'étain, le nickel, le cuivre ou autre métal de transition, ou un alliage du germanium avec l'un des matériaux choisis parmi : le silicium, l'étain, le nickel, le cuivre ou autre métal de transition.

En particulier, l'étape d'obtention du produit comporte une étape de fonctionnalisation des nanoéléments comprenant le dépôt d'une couche fonctionnelle au niveau desdits nanoéléments.

L'invention est aussi relative à un procédé de fabrication d'une électrode comportant une étape de formation de ladite électrode à partir du produit obtenu à partir du procédé de fabrication tel que décrit.

L'invention est aussi relative à une poudre comportant une pluralité de grains électriquement conducteurs sur lesquels sont fixés des nanoéléments, les nanoéléments ont une dimension latérale maximale comprise entre 1nm et 100nm avec une distribution d'écart-type inférieur ou égal à 50% et une longueur allant de 100nm à 50µm.

L'invention est aussi relative à une électrode pour élément de stockage d'énergie, ladite électrode comprenant la poudre telle que décrite dont les grains de la pluralité de grains électriquement conducteurs sont solidaires entre eux par un liant.

L'invention est aussi relative à un élément de stockage d'énergie comprenant une électrode, notamment anode, formée par l'électrode de telle que décrite ou une électrode obtenue par le procédé fabrication de l'électrode tel que décrit, notamment ledit élément de stockage est une batterie au lithium-ion.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 illustre différentes étapes d'un procédé de fabrication d'un produit comprenant des nanoéléments selon un mode d'exécution particulier de l'invention,
- la figure 2 illustre différentes étapes d'un procédé de fabrication d'un produit comprenant des nanoéléments selon un autre mode d'exécution particulier de l'invention,
- les figures 3 et 4 illustrent une étape additionnelle mise en œuvre pour former un dépôt d'une couche fonctionnelle, notamment respectivement réalisé après les différentes étapes des figures 1 et 2.

### Description de modes préférentiels de l'invention

Le procédé décrit ci-après permet une fabrication facilitée d'un produit comportant des nanoéléments formés par un matériau adapté à l'utilisation future desdits nanoéléments, en particulier une utilisation pour former une électrode (notamment anode) d'une supercapacité, d'une batterie, ou plus généralement d'un élément de stockage d'énergie.

Bien que le silicium soit préféré pour rentrer dans la composition des nanoéléments, la présente invention peut aussi s'appliquer à d'autres matériaux. Notamment, si le produit est destiné à former une électrode d'un élément de stockage d'énergie, lesdits autres matériaux peuvent être du type susceptible d'intercaler un électrolyte dudit élément de stockage d'énergie, notamment un électrolyte à ions lithium. Des exemples seront détaillés par la suite.

Dans la présente description, un nanoélément se présente avantageusement sous la forme d'un élément allongé tel un fil. Dans le domaine, le nanoélément peut être considéré comme étant un nanofil. Ainsi, le terme nanoélément(s) utilisé dans la présente description peut être remplacé par nanofil(s), ou inversement. Typiquement, les dimensions d'un nanoélément ou nanofil peuvent être comprises entre 100nm et 50µm pour sa longueur et comprises entre 1nm et 100nm pour ses dimensions latérales, avec préférentiellement un rapport de la longueur sur la largeur supérieur ou égal à 10.

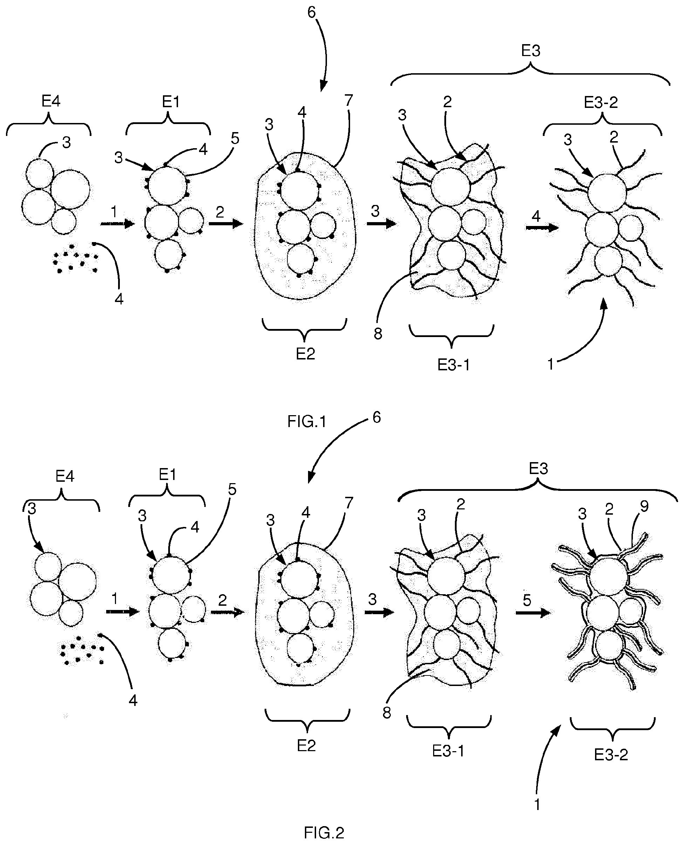

Les figures 1 et 2 illustrent un procédé de fabrication d'un produit 1 comprenant des nanoéléments 2.

Selon une mise en œuvre particulière, le procédé peut comporter une étape de fourniture E1 d'une pluralité de grains 3 électriquement conducteurs associés à un catalyseur 4 destiné à la croissance des nanoéléments 2.

De préférence, la pluralité de grains 3 électriquement conducteurs associés au catalyseur 4 se présente sous la forme d'une poudre lorsqu'elle est fournie (étape E1).

En particulier, par « la pluralité de grains 3 électriquement conducteurs associés au catalyseur 4 », on entend que le catalyseur 4 est fixé à la surface d'au moins une partie des grains de la pluralité de grains. C'est-à-dire que le catalyseur 4 est distinct des grains 3 mais solidaire d'au moins une partie de ces derniers. Par « solidaire de » on entend ici « fixé à », par exemple par affinité chimique.

Le catalyseur 4 permet de former des sites de croissance des nanoéléments.

Notamment, l'étape de fourniture E1 de la pluralité de grains 3 électriquement conducteurs associés au catalyseur 4 est telle que le catalyseur 4 comporte une pluralité d'éléments catalyseurs 4, et au moins un (de préférence plusieurs ou chaque) grain 3 de la pluralité de grains électriquement conducteurs comprend une surface 5 sur laquelle au moins un des éléments catalyseurs 4 de la pluralité d'éléments catalyseurs 4 est fixé. Notamment, tout ou partie des grains 3 de la pluralité de grains électriquement conducteurs peut comporter sur sa surface 5 (dite surface extérieure) plusieurs éléments catalyseurs 4 distincts. Autrement dit, les éléments catalyseurs 4 décorent ponctuellement des grains 3 de la pluralité de grains électriquement conducteurs pour former des sites de croissance des nanofils 2. En ce sens, on comprend que l'étape de fourniture E1 est configurée de telle sorte que tout ou partie des grains 3 de la pluralité de grains électriquement conducteurs comportent des zones préférentielles de croissance des nanoéléments 2 formées par des éléments catalyseurs 4 disposés à la surface 5 de tout ou partie des grains 3 de la pluralité de grains électriquement conducteurs.

Avantageusement, 50% des grains de la pluralité de grains sont décorés par au moins un élément catalyseur.

Autrement dit, lorsque le catalyseur est associé auxdits grains, soit chaque grain est fixé à au moins un élément catalyseur (cas idéal), soit une partie des grains est vierge d'éléments catalyseurs (cas qui sera la plus souvent rencontré).

En fait, lorsque l'on forme les grains sur lesquels des éléments catalyseurs sont fixés, il est utilisé des grains vierges que l'on mélange au catalyseur, les probabilités d'hybridation sont donc telles que dans la plupart des cas des éléments catalyseurs se fixent à certains grains (au moins un grain) tout en laissant d'autres grains vierges de tout élément catalyseur. Ensuite, il est difficile de trier les grains vierges de ceux qui ne le sont pas, ainsi, au terme de l'obtention du produit décrit ci-après les grains à la surface desquels au moins un élément catalyseur était fixé avant l'étape de croissance sont fixés à au moins un nanoélément correspondant et il restera des grains sans nanoéléments.

On a parlé ci-dessus d'une mise en œuvre particulière dans le sens où lorsque la pluralité de grains 3 électriquement conducteurs est fournie, elle n'est pas forcément déjà associée au catalyseur 4. C'est-à-dire que selon une réalisation le catalyseur 4 n'est pas directement solidaire des grains 3 lorsqu'il est fourni.

Autrement dit, de manière plus générale, le procédé de fabrication comprend une étape de formation E2 d'un mélange 6 comprenant la pluralité de grains 3 électriquement conducteurs, le catalyseur 4 distinct desdits grains 3 de la pluralité de grains électriquement conducteurs (distinct dans le sens où le catalyseur 4 et les grains 3 sont des entités différentes associées ou dissociées), et d'un réactif 7 comprenant un précurseur du matériau destiné à former les nanoéléments 2. De préférence, le réactif est un liquide ou en suspension (de particules solides) dans un liquide, notamment liquide dans les conditions normales de température et de pression. Ainsi, le mélange 6 est facile à manipuler et l'industrialisation du procédé de fabrication est simplifiée. Avantageusement, afin de faciliter la manipulation, le mélange total 6 est une suspension liquide contenant au moins les grains, le catalyseur et le précurseur.

On comprend que lorsque le mélange 6 est formé, le catalyseur 4 peut être, selon la réalisation, solidaire, ou non, de tout ou partie desdits grains 3 de la pluralité de grains électriquement conducteurs. Plus particulièrement, lorsque l'étape E1 est mise en œuvre, le procédé de fabrication comprend ladite étape E1 réalisée au préalable de l'étape de formation E2.

Dans la présente description, il est aussi utilisé les termes « matériau intercalant » pour parler du matériau destiné à former les nanoéléments 2. Ceci est notamment valable lorsque le produit obtenu est destiné à être utilisé pour former une électrode configurée pour intercaler les ions d'un électrolyte d'un élément de stockage d'énergie.

Bien que le catalyseur 4 soit associé (association réalisée au préalable de l'étape E2) ou, destiné à être associé (association réalisée au cours de l'étape E2), aux grains 3 de la pluralité de grains électriquement conducteurs, il est considéré comme étant distinct desdits grains 3 dans le sens où il forme une entité différente, notamment formée par un matériau différent de celui formant lesdits grains 3.

Les grains 3 de la pluralité de grains électriquement conducteurs sont formés par un matériau carboné, un composé organique électriquement conducteur, un composé organométallique électriquement conducteur, ou un matériau inorganique électriquement conducteur comme une céramique. Le matériau carboné peut être une forme monodimensionnelle, bidimensionnelle ou tridimensionnelle de carbone de la taille nano- ou micrométrique: particules, fibres, feuilles, des solides poreux, etc. Préférentiellement, les grains 3 sont constitués de noir de carbone, de graphite, de nanotubes de carbone, de fibres de carbone, de graphène, de mousses de carbone ou de carbone poreux de texture contrôlée, ou de mélange de ces différentes formes de carbone.

On comprend alors que la définition du terme grain 3 dans la présente description est à prendre au sens large. Ainsi, un grain 3 peut se présenter sous la forme d'un corps sphérique, allongé, ou structuré selon une forme souhaitée. Lorsque la pluralité de grains 3 se retrouve dans un état sec, elle forme alors une poudre électriquement conductrice.

Le catalyseur 4 peut aussi être choisi parmi des nanoparticules d'un métal, d'un composé bimétallique, d'un oxyde métallique, ou d'un nitrure-métallique. Les nanoparticules d'un métal sont notamment des particules d'or, de cobalt, de nickel, de bismuth, d'étain, de fer, d'indium, d'aluminium, de manganèse, ou d'iridium. Les nanoparticules d'un composé bimétallique sont notamment des nanoparticules de MnPt₃ ou FePt. Les nanoparticules d'un oxyde métallique sont notamment des nanoparticules d'oxyde ferrique. Les nanoparticules forment alors les éléments catalyseurs 4 visés dans la présente description. Les matériaux visés dans le présent paragraphe sont tous compatibles avec une croissance de nanofils en silicium.

Préférentiellement, le catalyseur 4 est constitué de nanoparticules d'or. Les nanoparticules d'or mises en œuvre dans le procédé selon l'invention peuvent être synthétisées selon un procédé connu de l'article « Synthesis of Thiol-derivatised Gold Nanoparticles in a Two-phase Liquid-Liquid System » de Brust et al. publié dans J. CHEM. SOC., CHEM. COMMUN., 1994 pages 801 et 802.

De manière générale, le diamètre des éléments catalyseurs (ou nanoparticules de catalyseur dans l'exemple) peut être compris entre 1nm et 100 nm. La notion de diamètre est valable si les éléments catalyseurs 4 adoptent la forme de sphère, sinon on considère que la plus grande dimension des élements catalyseurs 4 peut être comprise entre 1nm et 100nm.

Le matériau destiné à former les nanoéléments 2 (et donc son précurseur) peut être choisi de telle sorte que ledit matériau comporte du silicium, du germanium ou un alliage du silicium avec l'un des matériaux choisis parmi : le germanium, l'étain, le nickel, le cuivre ou autre métal de transition, ou un alliage du germanium avec l'un des matériaux choisis parmi : le silicium, l'étain, le nickel, le cuivre ou autre métal de transition. L'homme du métier sera donc à même de choisir le précurseur adapté à l'obtention de nanoéléments dans le matériau visé dans le présent paragraphe. Par ailleurs, dans la liste donnée ci-dessus du matériau destiné à former les nanoéléments, les catalyseurs compatibles pour la liste complète sont l'or, le nickel, le fer ainsi que leurs oxydes ou leurs nitrures, pour le silicium tous les catalyseurs visés précédemment peuvent aussi être utilisés.

Par exemple, pour le matériau silicium, le précurseur pourra être un ou plusieurs silane(s) organique(s) par exemple le diphénylsilane, le monophénylsilane, le triphénylsilane qui présentent l'intérêt d'être stables à l'air, ou un autre silane organique. Le réactif 7 peut contenir aussi une source de dopant du matériau intercalant, par exemple la diphénylphosphine ou le triphénylborane, qui fournissent des atomes de P ou B pour doper le silicium. Le réactif 7 peut contenir éventuellement un solvant.

Le procédé de fabrication comporte aussi une étape d'introduction du mélange 6 dans une enceinte d'un réacteur et de mise à une pression inférieure ou égale à 1 bar du réacteur (pression absolue). Le réacteur est ensuite fermé. Ainsi, la pression dans le réacteur est inférieure ou sensiblement égale à la pression atmosphérique au moment de la fermeture du réacteur.

Enfin, de manière générale, le procédé de fabrication comporte une étape d'obtention E3 du produit 1 à partir du mélange 6, ladite étape d'obtention E3 comprenant une étape de croissance E3-1 desdits nanoéléments 2 à partir du catalyseur 4, alors associé auxdits grains 3 de la pluralité de grains électriquement conducteurs. Ladite étape de croissance E3-1 étant mise en œuvre par une étape de traitement thermique appliquée audit mélange 6. En particulier, l'étape de croissance E3-1 est telle qu'à son terme les nanoéléments 2 s'étendent à partir de grains 3 de la pluralité de grains électriquement conducteurs et sont formés par ledit matériau.

De manière préférentielle, l'étape d'obtention E3 du produit 1 est telle qu'au terme de ladite étape d'obtention E3, ledit produit 1 obtenu se présente sous la forme d'une poudre munie de grains 3 électriquement conducteurs à partir desquels s'étendent les nanoéléments 2. Comme évoqué précédemment, la poudre peut aussi comporter, le cas échéant, des grains issus de la pluralité de grains vierges de tout nanoéléments. En particulier, plusieurs nanoéléments 2 s'étendent de chaque grain 3 de la pluralité de grains électriquement conducteurs.

En particulier, juste avant la mise en œuvre de l'étape de croissance, le catalyseur 4 comportant une pluralité d'éléments catalyseurs 4, au moins un (de préférence plusieurs ou chaque) grain 3 de la pluralité de grains électriquement conducteurs comprend une surface 5 sur laquelle au moins un des éléments catalyseurs de la pluralité d'éléments catalyseurs 4 est formé. Avantageusement, 50% des grains portent au moins un élément catalyseur. Notamment, tout ou partie des grains 3 de la pluralité de grains peut comporter sur sa surface 5 (dite surface extérieure) plusieurs éléments catalyseurs 4 distincts. Autrement dit, les éléments catalyseurs 4 décorent ponctuellement les grains 3 de la pluralité de grains électriquement conducteurs.

Selon une réalisation particulière, l'étape de traitement thermique (permettant la croissance - coïncidant avec l'étape E3-1 des figures 1 et 2) appliquée au mélange 6 est réalisée à une température comprise entre 270°C et 600°C, et préférentiellement comprise entre 270°C et 450°C, sous atmosphère non oxydante. Cette étape de traitement thermique peut être mise en œuvre grâce à l'utilisation de l'enceinte du réacteur dans laquelle est placé le mélange 6, ladite enceinte étant placée à la température susmentionnée. Ainsi, le traitement thermique proposé par la présente invention permet d'obtenir un produit 1 plus facilement que dans le cadre de l'art antérieur où les techniques nécessaires sont plus complexes à maîtriser. Au cours de l'étape E3, la pression dans le réacteur peut augmenter du fait du traitement thermique. Par exemple, la pression peut monter jusqu'à 10 bars. De préférence, cette pression dépend de la température du traitement thermique et n'est pas contrôlée ou pilotée. De préférence, le produit est obtenu à une pression supérieure à 1 bar.

En particulier, par « atmosphère non oxydante », on entend dans la présente description à l'abri de l'air par exemple sous atmosphère d'argon, d'azote ou d'hydrogène par exemple à pression ambiante ou sous vide moyen ou poussé pour limiter la présence d'oxygène.

L'étape d'introduction du mélange 6 dans une enceinte d'un réacteur et de mise à une pression inférieure ou égale à 1 bar du réacteur est une étape intermédiaire entre les étapes E2 et E3.

Selon une réalisation, le procédé de fabrication des nanoéléments 2 comporte une étape de réalisation E4 de la pluralité de grains 3 électriquement conducteurs associés au catalyseur 4 comprenant une étape de placement des grains 3 de la pluralité de grains et du catalyseur 4 dans un solvant, et une étape de séchage permettant d'évaporer le solvant d'où il résulte l'association du catalyseur 4 avec lesdits grains 3 de la pluralité de grains électriquement conducteurs, c'est-à-dire ce qui est fourni en étape E1. On comprend alors que cette étape de réalisation E4 est mise en œuvre au préalable de l'étape E1. Alternativement l'étape de réalisation de la pluralité de grains 3 électriquement conducteurs associés au catalyseur 4 peut être réalisée au cours de l'étape E2.

En particulier, l'étape de réalisation E4 de la pluralité de grains 3 électriquement conducteurs associés au catalyseur 4 consiste à une mise en contact du catalyseur 4 avec les grains 3 de la pluralité de grains électriquement conducteurs à atmosphère ambiante dans un solvant adéquat selon le catalyseur 4. Autrement dit, une fois les grains 3 de la pluralité de grains électriquement conducteurs et le catalyseur 4 dans le solvant, le catalyseur 4 va se déposer, notamment sous la forme d'îlots à la surface d'au moins une partie desdits grains 3. Après mise en contact du catalyseur 4 avec lesdits grains 3 de la pluralité de grains électriquement conducteurs, le solvant est retiré, par exemple dans un évaporateur rotatif, ou par centrifugation et élimination du solvant de sorte à obtenir une poudre contenant les grains 3 de la pluralité de grains électriquement conducteurs associés au catalyseur 4. En particulier, le ratio en masse de catalyseur 4 et des grains 3 de la pluralité de grains électriquement conducteurs est préférentiellement compris entre un pour un million et un pour dix, ceci étant notamment applicable à toutes les réalisations de l'invention. Selon un exemple, le solvant peut être de l'eau, du chloroforme ou une huile aliphatique comme l'hexane, puis il sera séché à l'air ou sous vide pour que le catalyseur se dépose de manière adaptée sur les grains 3 de la pluralité de grains électriquement conducteurs.

Selon une réalisation, la surface du catalyseur 4 peut être recouverte d'un ligand tel que le dodécanethiol. Le ligand empêche les particules de catalyseur de s'agglomérer. De plus, le ligand ayant une grande affinité chimique avec le carbone, il améliore la fixation sur les grains. Les nanoparticules de catalyseur recouvertes du ligand, formant alors les éléments catalyseur 4, peuvent être dispersées dans un solvant tel que le toluène, notamment à une concentration de 50 mg/mL, pour constituer une solution mère de nanoparticules de catalyseur à mélanger avec les grains 3 de la pluralité de grains électriquement conducteurs.

Selon une réalisation, l'étape de formation du mélange E2 peut consister en la mise en contact des grains 3 de la pluralité de grains électriquement conducteurs (se présentant notamment sous la forme de poudre électriquement conductrice) associés (ou pas encore) au catalyseur 4 avec le réactif 7. Comme précisé ci-avant, le réactif 7 contient au moins le précurseur du matériau destiné à former les nanoéléments 2. Le réactif 7 peut se présenter sous la forme d'un liquide ou d'une poudre en suspension dans un liquide. Lorsque le réactif 7 se présente sous la forme d'une poudre, les grains 3 de la pluralité de grains électriquement conducteurs sont associés audit catalyseur 4 et le réactif 7 est mélangé finement auxdits grains 3. Par exemple, on peut utiliser une source solide de silicium, par exemple du triphenylsilane, dans un solvant liquide, par exemple du squalane.

Le réactif 7 contient une source de dopants du matériau destiné à former les nanoéléments pour modifier ses caractéristiques électriques, par exemple si l'on souhaite que ces derniers soient électriquement conducteurs et naturellement dopés au cours de leur croissance. Le réactif peut aussi comporter un solvant, un tel solvant permet d'améliorer le mélange intime des grains et des éléments précurseurs, il peut aussi être choisi pour être source de matériau qui constituera la matrice 8 puis ultérieurement la couche 9.

Si on souhaite que les nanoéléments 2 soient dopés lors de leur croissance, la source de dopant peut être choisie de manière connue de l'état de l'art pour le matériau destiné à former les nanoéléments. Dans le cas du silicium, la source de dopant peut être choisie parmi les organophosphines, telles que la diphénylphosphine ; les organoboranes tels que le triphénylborane, l'anhydride diphénylborique ; les organoarsines ; les amines aromatiques, telles que la diphénylamine, ou la triphénylamine.

De manière générale, en cas de dopage électrique souhaité des nanoéléments, la proportion de source de dopant par rapport au précurseur du matériau destiné à former les nanoéléments 2 dans le réactif 7 est comprise entre un pour un million et un pour cinq en moles. Elle est préférentiellement de 0,001 à 1 % en moles.

Préférentiellement, le réactif 7 est mélangé à la poudre électriquement conductrice (les grains 3 de la pluralité de grains électriquement conducteurs) contenant le catalyseur 4 dans une proportion massique de 10% à 500%. De préférence, le réactif 7 est liquide dans les conditions normales de température et de pression.

Selon une mise en œuvre, le précurseur du matériau destiné à former les nanoéléments 2 comprend un ou plusieurs composés organiques ou organométalliques contenant le ou les éléments choisis pour ledit matériau. De préférence, le ou les composés organiques ou organométalliques sont liquides dans les conditions normales de température et de pression. Dans le cas du silicium, la source de silicium peut être un (ou plusieurs) composé silane ou un mélange de composés silanes. Le composé silane est notamment un organosilane, en particulier un organomonosilane, un organodisilane ou un organotrisilane, ou un silane simple de formule SiₙH₍₂ₙ₊₁₎ avec n allant de 1 à 10. L'organosilane peut être notamment un mono-, di-, triarylsilane tel que le monophenylsilane, le diphenylsilane, le triphenylsilane, ou un mono-, di-, tri-alkylsilanes tel que l'octylsilane.

Selon un mode de réalisation particulier, l'étape d'obtention E3 dudit produit comporte une étape de formation d'un produit intermédiaire comportant des grains 3 électriquement conducteurs, issus de la pluralité de grains électriquement conducteurs, à partir desquels s'étendent lesdits nanoéléments, et une matrice 8 enrobant au moins en partie lesdits grains 3 électriquement conducteurs et lesdits nanoéléments 2.

De préférence, la matrice 8 recouvre entièrement lesdits grains 3 et lesdits nanoéléments 2.

En particulier, le produit intermédiaire tel que décrit est obtenu au terme de l'application de l'étape de traitement thermique E3-1. La matrice 8 est donc formée par les résidus du réactif 7.

Selon un exemple, l'étape de traitement thermique E3-1 du mélange 6 formé est telle que ledit mélange 6 formé est placé dans un réacteur fermé sous vide ou sous atmosphère non oxydante et à une température comprise entre 270°C et 600°C, préférentiellement comprise entre 270°C et 450°C. La durée du traitement est de 1 minute à 1 jour, préférentiellement 1 heure. Dans cette gamme de température, le précurseur du matériau destiné à former les nanoéléments 2 subit une pyrolyse, c'est-à-dire une décomposition thermique conduisant à la formation de vapeurs de pyrolyse, qui en contact du catalyseur 4, conduisent à la croissance des nanoéléments 2 sur les grains 3 de la pluralité de grains électriquement conducteurs et au dépôt de la matrice 8.

En revenant au mode de réalisation particulier, dans un premier cas illustré en figure 1, l'étape d'obtention E3 du produit peut comporter une étape de retrait E3-2 de la matrice 8 du produit intermédiaire mise en œuvre par une étape de lavage du produit intermédiaire.

L'étape de lavage permet d'éliminer la matrice 8, pour libérer les nanoéléments 2, éventuellement dopés au cours de leur croissance, s'étendant à partir des grains 3 de la pluralité de grains électriquement conducteurs. Un lavage selon les usages de la personne de l'art, fonction du type de la matrice 8, permet d'effectuer cette étape. Par exemple, dans le cas d'une matrice 8 organique, il est procédé à un lavage aux solvants organiques non-polaires, purs ou en mélange, notamment l'hexane ou le toluène. Sinon dans le cas d'une matrice inorganique, on procède à un lavage acide ou basique adapté au type de matrice.

Dans le premier cas, si les nanoéléments 2 après l'étape de retrait de la matrice 8 ne sont pas électriquement conducteurs (par exemple dopés lors de leur croissance), il est alors possible de réaliser un dopage électrique de ces derniers. Par exemple, l'étape d'obtention E3 du produit 1 comporte, après l'étape de retrait de la matrice 8, une étape de dépôt d'une couche électriquement conductrice en particulier sur lesdits nanoéléments 2 ou une étape de dopage électrique desdits nanoéléments 2 postérieure à leur formation suivie d'un recuit.

En revenant au mode de réalisation particulier, dans un deuxième cas illustré en figure 2, l'étape d'obtention E3 peut comporter une étape de dépôt d'une couche électriquement conductrice 9 sur les nanoéléments 2 mise en œuvre par un traitement thermique de la matrice 8. Autrement dit, l'étape d'obtention E3 du produit 1 peut comporter une étape de chauffage du produit intermédiaire permettant la formation, à partir de la matrice 8, d'un revêtement 9 électriquement conducteur sur lesdits nanoéléments 2 (figure 2). Par exemple, cette étape de chauffage peut consister en un traitement thermique pour transformer par recuit la matrice 8 organique en un revêtement conducteur sur la surface des nanoéléments 2 préalablement synthétisés. Le traitement de recuit est notamment réalisé à une température comprise entre 600°C et 1500°C, préférentiellement entre 900°C et 1000°C. Dans cette gamme de température, la matrice 8 organique subit une décomposition thermique conduisant à la formation d'une couche graphitique qui revêt les nanoéléments 2 et les grains 3 de la pluralité de grains électriquement conducteurs.

Par exemple, l'étape de chauffage du produit intermédiaire est mise en œuvre par une étape de traitement thermique additionnel dudit produit intermédiaire à une température comprise entre 600°C et 1500°C, de préférence ladite température est comprise entre 900°C et 1000°C.

Ce deuxième cas illustré en figure 2 permet à la croissance des nanofils 2 (notamment de matériau intercalant) d'être suivie en « one-pot » par la synthèse du revêtement conducteur 9 sur les nanofils 2. Le revêtement conducteur 9 augmente la conductivité globale du produit 1 obtenu. Dans le cas de nanofils de silicium 2 couverts d'un revêtement de carbone 9, il a été montré dans l'état de l'art que le revêtement de carbone 9 limite la formation de la couche de passivation SEI (pour Solide Electrolyte Interface), et donc la perte de capacité en batterie lithium-ion dans les premiers cycles.

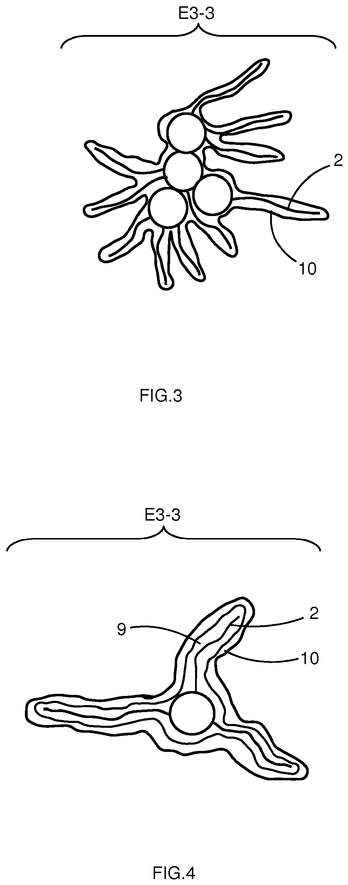

Selon un mode d'exécution applicable aux différentes réalisations, l'étape d'obtention E3 du produit 1 comporte une étape de fonctionnalisation E3-3 (figures 3 et 4) des nanoéléments 2 comprenant le dépôt d'une couche fonctionnelle 10 au niveau des nanoéléments 2. La figure 3 illustre l'étape E3-3 appliquée à la suite de la figure 1 notamment après l'étape E3-2, et la figure 4 illustre l'étape E3-3 appliquée à la suite de la figure 2 notamment après l'étape E3-2. La couche fonctionnelle 10 peut être organique ou inorganique. Par exemple, cette couche fonctionnelle 10 peut être une couche de passivation contre l'attaque électrochimique du matériau intercalant, ou une couche rédox active pour le stockage de charges à la surface de l'électrode obtenue à partir du produit 1.

Notamment, cette couche fonctionnelle 10 est déposée de sorte à entourer en tout ou partie les nanoéléments 2 avec ou sans interposition de matériau intermédiaire. On comprend alors que selon le mode de mise en œuvre de l'invention, la couche fonctionnelle 10 peut :
- directement être déposée à la surface extérieure des nanoéléments (mode visible des figures 1 et 3 où les nanoéléments 2 sont nus),
- directement être déposée à la surface extérieure de la couche électriquement conductrice (mode visible en figures 2 et 4 où les nanoéléments 2 sont recouverts par la couche électriquement conductrice 9).

De préférence, cette couche fonctionnelle 10 peut être une couche d'oxyde de silicium ou une couche de polymère ou une couche de diamant.

Lorsque la couche fonctionnelle 10 est une couche d'oxyde de silicium, les nanoéléments 2 sont préférentiellement des nanofils de silicium. Notamment, la couche d'oxyde de silicium peut être obtenue selon le procédé décrit par le document « Wide-voltage-window silicon nanowire electrodes for micro-supercapacitors via electrochemical surface oxidation in ionic liquide electrolyte » de N. Berton et al publié dans Electrochemistry Communication, 41 (2014) 31-34. L'avantage de la couche d'oxyde de silicium est d'augmenter la capacité spécifique lorsque le produit 1 obtenu est utilisé en tant qu'anode d'un élément de stockage d'énergie tel qu'une capacité.

Lorsque la couche fonctionnelle est une couche de polymère, les nanoéléments sont préférentiellement des nanofils de silicium. Notamment, la couche de polymère peut être obtenue selon le procédé électrochimique décrit dans le document « Novel hybrid micro-supercapacitor based on conducting polymer coated silicon nanowires for electrochemical energy storage » de D. Aradilla et al. publié dans RSC Advances 2014, 4, 26462-26467. Un tel revêtement polymère permet d'améliorer les densités d'énergie et de puissance des microsupercapacités.

Lorsque la couche fonctionnelle est une couche de diamant, cela permet de protéger l'électrode contre une attaque électrochimique même sous haute tension, et ainsi obtenir des condensateurs haute puissance.

Le procédé de fabrication du produit décrit dans la présente description autorise notamment une synthèse monotope (« one-pot » en anglais) en mélangeant tous les ingrédients nécessaires (poudre conductrice 3, source de matériau intercalant, catalyseur 4) pour obtenir un produit de base homogène, maniable, inoffensif, stable à l'air et prêt à utiliser (par exemple pour former une électrode). Un simple chauffage (traitement thermique) de cette masse mélangée dans un réacteur fermé sous vide ou sous une atmosphère non oxydante permet l'obtention d'un réseau interconnecté conducteur de nanofils de matériau intercalant fixés sur la poudre conductrice (dans ce cas les nanoéléments/nanofils sont connectés notamment électriquement entre eux). Le mélange de la poudre couverte de catalyseur avec le réactif permet une réaction de croissance des nanofils homogène dans tout le volume de poudre conductrice. Du fait de la simplicité de mise en œuvre et de la robustesse du mélange réactif, cette méthode de préparation est facilement portée à grande échelle par l'homme de l'art.

Autrement dit, l'étape d'obtention du produit 1 peut être mise en œuvre par une synthèse monotope du réactif 7 mis en présence des grains 3 de la pluralité de grains électriquement conducteurs et du catalyseur 4. Ceci étant notamment valable pour la réalisation de la figure 2.

En outre, le procédé de fabrication du produit décrit ci-avant permet un rendement élevé supérieur à 30% par rapport à la quantité de matériau intercalant introduit. Ceci permet la production du produit de l'invention en grande quantité dans un espace de synthèse réduit. La synthèse proposée est peu coûteuse parce qu'elle utilise des réactifs bon marché et stables à l'air et des conditions opératoires peu gourmandes en énergie, et parce que le rendement de synthèse est proche de 100%. L'industrialisation est donc facilitée comparé aux autres synthèses de produit contenant des nanofils de silicium et de carbone de l'état de l'art. Ce produit en forme de poudre noire est prêt à l'emploi par exemple comme matériau d'anode de batterie au lithium, en remplacement direct du graphite dans la chaine de production des anodes de batterie.

La possibilité de doper les nanofils de matériau intercalant permet d'augmenter leur conductivité. La conductivité du produit contenant des nanofils sur poudre conductrice s'en trouvera améliorée.

En outre, le procédé de fabrication du produit est peu gourmand en énergie. Toutes les étapes de préparation du produit, à l'exception de l'étape de traitement thermique, peuvent être réalisées à l'atmosphère ambiante et à température ambiante, évitant ainsi l'usage d'équipements complexes et consommateurs d'énergie comme des boîtes à gants ou des chambres à vide. L'étape de traitement thermique est par ailleurs peu exigeante d'une part sur la qualité de l'atmosphère (atmosphère non oxydante, sous vide ou pression proche de l'ambiante), d'autre part elle est peu consommatrice en puissance de chauffage : la température est peu élevée, la durée de chauffage est courte.

Selon le procédé de fabrication du produit décrit ci-avant, il est possible que le produit obtenu se présente sous la forme d'une poudre dont la taille des grains est au moins égale à la taille des grains de la poudre conductrice initiale (celle correspondant à la pluralité de grains avant croissance des nanofils). Le produit obtenu peut ainsi profiter des performances des nanofils de matériau intercalant, qui sont ordinairement obtenus comme une poudre de taille nanométrique, alors que la poudre est en fait de taille micrométrique. Cette différence de taille de grains permet une gestion plus aisée de la sécurité de production en réduisant le risque lié à la dissémination des nanopoudres.

Il est donné ci-après des exemples particuliers de réalisation,

Un premier exemple qui n'est pas conforme à l'invention consiste à réaliser une synthèse d'un lot de composite de nanofils de silicium non dopés et de noir de carbone avec un lavage aux solvants. Dans un premier temps, des nanoparticules d'or sont synthétisées selon le procédé décrit dans l'article de Brust et al. évoqué ci-avant. Leur diamètre est de 1 nm à 4 nm, et leur surface est recouverte de dodécanethiol. Ces nanoparticules sont ensuite dispersées dans du toluène à une concentration de 50 mg/ml pour constituer une solution mère de nanoparticules d'or. Dans un deuxième temps, la poudre conductrice, notamment, le noir de carbone notamment avec des grains de 40nm à 60nm de diamètre., est utilisé tel quel sans préparation supplémentaire. La source de silicium, notamment le diphenylsilane, est utilisée telle quelle sans préparation supplémentaire. Dès lors, dans un troisième temps 40 µL de solution mère de nanoparticules d'or sont mélangés avec 100 mg de noir de carbone et 370 µL de diphenylsilane dans 20 mL d'hexane sec à l'atmosphère ambiante pendant 1 heure. L'hexane est évaporé en utilisant un évaporateur rotatif. Le solide obtenu est déposé dans un réacteur constitué d'un tube de 16 mm de diamètre extérieur en pyrex d'épaisseur 1 mm. Le réacteur est ensuite placé sur une rampe à vide et scellé au chalumeau à 15 cm du fond environ. Dans un quatrième temps, le réacteur est placé dans un four à 450°C pendant 1 h, puis il est sorti du four et laissé à refroidir pendant 30 minutes à température ambiante. Le réacteur est rompu dans les conditions ambiantes. Il résulte du traitement thermique que la poudre de carbone est recouverte de nanofils de silicium (m=300 mg pour le produit obtenu en étape E3-1 de la figure 1) et d'une matrice organique de polyphénylsilanes. Cette poudre est alors transférée du tube en pyrex dans un tube de centrifugation en plastique de 40 mL avec 10 mL de chloroforme. Un bain à ultrasons est utilisé pour obtenir une suspension fine du composite. Enfin, on ajoute 20 mL d'éthanol à la suspension du composite dans le chloroforme. Le mélange est centrifugé 5 minutes à 8000 rpm, le solvant est retiré et remplacé par 10 mL de toluène. On ajoute 20 mL d'éthanol à la suspension du composite dans le toluène. Le mélange est centrifugé 5 minutes à 8000 rpm, le solvant est retiré pour obtenir après un séchage sous vide un produit solide noir (m = 135 mg pour le produit obtenu en étape E3-2 de la figure 1), prêt à utiliser correspondant au produit obtenu décrit ci-avant.

Un deuxième exemple qui n'est pas conforme à l'invention consiste à réaliser une synthèse d'un lot de composite de nanofils de silicium non dopés et de noir de carbone recouvert d'un revêtement de carbone. Dans un premier temps, les nanoparticules d'or sont synthétisées selon le procédé décrit dans l'article de Brust et al. évoqué ci-avant. Leur diamètre est de 1 nm à 4 nm, leur surface est recouverte de dodécanethiol. Les nanoparticules sont alors dispersées dans le toluène à une concentration de 50 mg/ml pour constituer une solution mère de nanoparticules d'or. Dans un deuxième temps, la poudre conductrice, notamment le noir de carbone (par exemple avec des grains de 40nm à 60nm de diamètre), est utilisée telle quelle sans préparation supplémentaire. La source de silicium, notamment le diphenylsilane, est utilisée telle quelle sans préparation supplémentaire. Dans un troisième temps, 40 µL de solution mère de nanoparticules d'or sont mélangés avec 100 mg de noire de carbone et 370 µL de diphenylsilane dans 20 mL d'hexane sec à l'atmosphère ambiante pendant 1 heure. L'hexane est évaporé en utilisant un évaporateur rotatif. Le solide obtenu est déposé dans un réacteur (tube de 16 mm de diamètre extérieur en pyrex d'épaisseur 1 mm). Le réacteur est ensuite placé sur une rampe à vide et scellé au chalumeau à 15 cm du fond environ._Dans un quatrième temps, le réacteur est placé dans un four à 450°C pendant 1 h, puis il est sorti du four et laissé à refroidir pendant 30 minutes à température ambiante. Le réacteur est rompu dans les conditions ambiantes. Dans un cinquième temps, il résulte de l'ouverture du réacteur la récupération d'une poudre conductrice recouverte de nanofils de silicium (m=300 mg pour le produit obtenu en étape E3-1 de la figure 2) et d'une matrice organique de polyphénylsilanes. Cette poudre est transférée du tube en pyrex dans un réacteur constitué d'un tube de 16 mm de diamètre extérieur en quartz d'épaisseur 1 mm. Le réacteur est ensuite placé sur une rampe à vide et scellé au chalumeau à 15 cm du fond environ. Dans un sixième temps, le réacteur est placé dans un four à 900°C pendant 1 h, puis il est sorti du four et laissé à refroidir pendant 1 heure à température ambiante. Le réacteur est rompu dans les conditions ambiantes pour récupérer un produit solide noir (m = 255 mg pour le produit obtenu en étape E3-2 de la figure 2) prêt à utiliser correspondant au produit obtenu décrit ci-avant.

Un troisième exemple consiste à réaliser une synthèse d'un lot de composite de nanofils de silicium dopés au phosphore et de noir de carbone par exemple avec des grains de 40nm à 60nm de diamètre. Dans un premier temps, les nanoparticules d'or sont synthétisées selon le procédé décrit dans l'article de Brust et al. Leur diamètre est de 1 à 4 nm, leur surface est recouverte de dodécanethiol. Elles sont dispersées dans le toluène à une concentration de 50 mg/ml pour constituer une solution mère de nanoparticules d'or. Dans un deuxième temps,_la poudre conductrice, notamment, le noir de carbone par exemple avec des grains de 40nm à 60nm de diamètre, est utilisée telle quelle sans préparation supplémentaire. La source de silicium, notamment le diphenylsilane, est utilisée telle quelle sans préparation supplémentaire. La source de phosphore (le dopant), notamment le diphenylphosphine, est utilisée telle quelle sans préparation supplémentaire. Dans un troisième temps, 40 µL de solution mère de nanoparticules d'or sont mélangés avec 100 mg de noir de carbone, 3.5 µL de diphenylphosphine et 370 µL de diphenylsilane dans 20 mL d'hexane sec à l'atmosphère ambiante pendant 1 heure. L'hexane est évaporé en utilisant un évaporateur rotatif. Le solide obtenu est déposé dans un réacteur (tube de 16 mm de diamètre extérieur en pyrex d'épaisseur 1 mm). Le réacteur est ensuite placé sur une rampe à vide et scellé au chalumeau à 15 cm du fond environ. Dans un quatrième temps, le réacteur est placé dans un four à 450°C pendant 1 h, puis il est sorti du four et laissé à refroidir pendant 30 minutes à température ambiante. Le réacteur est rompu dans les conditions ambiantes. Dans un cinquième temps le support carbonique couvert de nanofils de silicium (m=260 mg), polyphenylphosphines et polyphenylsilanes est transféré du tube en pyrex dans un tube de centrifugation en plastique de 40 mL avec 10 mL de chloroforme. Un bain à ultrasons est utilisé pour obtenir une suspension fine du composite. Enfin, dans un sixième temps,_on ajoute 20 mL d'éthanol à la suspension du composite dans le chloroforme. Le mélange est centrifugé 5 minutes à 8000 rpm, le solvant est retiré et remplacé par 10 mL de toluène. On ajoute 20 mL d'éthanol à la suspension du composite dans le toluène. Le mélange est centrifugé 5 minutes à 8000 rpm, le solvant est retiré pour obtenir après un séchage sous vide un produit solide noire (m = 115 mg), prêt à utiliser correspondant au produit obtenu décrit ci-avant.

L'invention est aussi relative à un procédé de fabrication d'une électrode. Un tel procédé de fabrication d'électrode comporte une étape de formation de ladite électrode à partir du produit obtenu à partir du procédé de fabrication du produit décrit ci-avant. Cette étape de formation de l'électrode peut :
- directement utiliser le produit comprenant une pluralité de grains électriquement conducteurs, dont au moins deux nanoéléments s'étendant de chaque grain de la pluralité de grains électriquement conducteurs,
- utiliser le produit obtenu selon le procédé de fabrication,
- mettre en œuvre le procédé de fabrication du produit selon ce qui est décrit dans la présente description.

Notamment, le produit obtenu est tel qu'il se présente, selon un mode préférentiel, sous la forme d'une poudre comportant une pluralité de grains électriquement conducteurs sur lesquels sont fixés des nanoéléments. Les nanoéléments ont une dimension latérale maximale (ou diamètre le cas échéant) de 1nm à 100nm avec une distribution d'écart-type inférieur ou égal à 50% et une longueur de 100nm à 50µm.. En outre, la poudre peut ici comporter toutes les caractéristiques structurelles décrite dans la présente description en relation avec le produit obtenu sans qu'elle soit forcément obtenue par le procédé de fabrication.

L'invention est aussi relative à une électrode pour élément de stockage d'énergie, ladite électrode comprenant la poudre décrite dans le paragraphe ci-dessus. Dans le cadre de l'électrode, les grains 3 de la pluralité de grains électriquement conducteurs sont solidaires entre eux par un liant. Les liants sont bien connus de l'art antérieur, on peut notamment citer le carboxyméthylcellulose (CMC).

Le produit obtenu peut être utilisé comme matériau actif dans les électrodes d'accumulateur électrochimique, en particulier dans les anodes de batteries lithium-ion. Il peut être utilisé comme matériau d'électrode de super-condensateur. Il peut être utilisé comme électrode pour l'électrocatalyse, l'électroréduction des ions pour la dépollution des eaux, la récupération d'ions dissous dans des phases liquides par réduction, la croissance de biofilms dans des biopiles.

En ce sens, l'invention est aussi relative à un élément de stockage d'énergie comprenant une électrode, notamment anode, formée par l'électrode telle que décrite ou une électrode obtenue selon le procédé de fabrication de l'électrode, notamment ledit élément de stockage est une batterie au lithium-ion.

La très grande surface spécifique du réseau interconnecté conducteur de nanofils assure à l'électrode, obtenue selon le procédé de fabrication de l'électrode, une densité de courant très importante, tant dans les batteries que dans les condensateurs. L'interconnexion électrique est assurée d'une part par les contacts entre les nanofils, mais aussi par le contact entre les nanofils et les grains de la pluralité de grains sur lesquels ils ont crû. Un contrôle facile du ratio entre matériau intercalant et les grains de la pluralité de grains électriquement conducteurs permet la synthèse de composites avec des densités énergétiques choisies. Typiquement, le ratio en masse matériau intercalant/grains de la pluralité de grains électriquement conducteurs avant croissance est intéressant dans les proportions 10/90 à 90/10.

Il a été évoqué ci-avant que les nanofils peuvent être dopés durant leur croissance, ou après leur croissance. Dans le cas du silicium comme matériau intercalant, la conductivité dudit matériau intercalant, intrinsèquement faible pour le silicium pur, peut ainsi être augmentée pour donner au matériau intercalant un comportement métallique et réduire les résistances en série. De cette façon, l'électrode obtenue avec le produit provoque moins de pertes de tension et moins d'échauffement.

Les grains de la pluralité de grains électriquement conducteurs permettent, d'une part, de limiter la diffusion du catalyseur pendant la croissance des nanofils (de cette façon, les nanoparticules de catalyseur restent de petite taille et les nanofils de matériau intercalant de l'invention ont un diamètre homogène et fin) et, d'autre part, d'améliorer les caractéristiques du produit obtenu comme un nouveau matériau d'anode de batteries lithium-ion (la conductivité électrique du produit obtenu empêche l'agrégation des nanofils de matériau intercalant et maintient la porosité pour absorber le changement de volume du matériau intercalant au cours du cyclage).

La très grande surface spécifique, alliée à un dopage adéquat des nanofils pour assurer une forte conductivité du réseau et un traitement de surface adéquat pour assurer une grande stabilité chimique à long terme du réseau, permet d'obtenir des super-condensateurs, micro-super-condensateurs ou ultra-micro-super-condensateurs avec une grande densité d'énergie.

Par ailleurs, le diamètre des nanofils très fin et homogène assure une grande stabilité mécanique de l'électrode lors des cycles de lithiation/délithiation dans les batteries au lithium, et permet d'obtenir des batteries au lithium plus durable que l'état de l'art. En effet, préférentiellement, les nanofils de matériau intercalant présentent à la fois un diamètre fin, c'est-à-dire inférieur à 100nm, et homogène sur l'ensemble des nanofils, c'est-à-dire présentant moins de 50% d'écart type dans la distribution des diamètres, et une grande longueur, de 100nm à 50 microns. Cette qualité confère au produit obtenu une très grande surface spécifique, la surface active de l'électrode fabriqué à partir du produit obtenu est donc plus élevée pour un même volume ou une même masse qu'un autre type d'électrode, ce qui accroît la densité de courant de l'élément de stockage d'énergie électrique incluant ladite électrode. Le revêtement conducteur offre suffisamment d'espace structuré pour absorber le changement de volume des nanofils de matériau intercalant au cours du cyclage.

La présente invention propose une méthode de synthèse one-pot à grande échelle permettant notamment la production d'un produit constitué de nanofils de silicium très homogènes en diamètre greffés sur une matrice conductrice, notamment de carbone (par exemple des nano- ou microparticules de noir de carbone ou de graphite), utilisant des réactifs et procédés à bas coûts et respectueux de l'environnement. La méthode est très versatile est permet d'ajuster les caractéristiques du produit :
- les proportions massiques entre le silicium et la matrice peuvent être facilement ajustée en changeant les proportions de précurseurs.
- Le diamètre des nanofils de silicium peut être aisément contrôlé en changeant la taille des catalyseurs de croissance.
- La conductivité électrique des nanofils de silicium peut être ajustée par dopage in situ.
- Les nanofils de silicium peuvent être recouverts d'une fine couche de protection, en particulier d'une couche de carbone.

Ce produit peut être utilisé comme matériau d'anode de batterie lithium-ion, ou comme matériau d'électrode de super-condensateur.

## Revendications

1. Procédé de fabrication d'un produit (1) comprenant des nanoéléments (2), ledit procédé comprenant les étapes suivantes :
- une formation (E2) d'un mélange (6) comprenant une pluralité de grains (3) électriquement conducteurs, un catalyseur (4) distinct des grains (3) de la pluralité de grains électriquement conducteurs, et un réactif (7) liquide ou sous forme d'une suspension de particules solides dans un solvant liquide et comprenant un précurseur du matériau destiné à former les nanoéléments (2), les grains (3) étant formés par un matériau carboné ou un composé organique électriquement conducteur ou un composé organométallique électriquement conducteur ou un matériau inorganique électriquement conducteur comme une céramique, et le matériau destiné à former les nanoéléments (2) étant choisi de telle sorte que ledit matériau comporte du silicium, du germanium ou un alliage du silicium avec l'un des matériaux choisis parmi : le germanium, l'étain, le nickel, le cuivre ou autre métal de transition, ou un alliage du germanium avec l'un des matériaux choisis parmi : le silicium, l'étain, le nickel, le cuivre ou autre métal de transition,
- une introduction du mélange (6) dans une enceinte d'un réacteur et une mise à une pression inférieure à 1 bar du réacteur,
- une fermeture du réacteur,
- une obtention (E3) du produit (1) à partir du mélange (6) comprenant une étape de croissance (E3-1) desdits nanoéléments (2) à partir du catalyseur (4), alors associé auxdits grains (3) de la pluralité de grains électriquement conducteurs, ladite étape de croissance (E3-1) étant mise en œuvre par une étape de traitement thermique appliquée audit mélange (6),
le réactif (7) contenant une source de dopants du matériau destiné à former lesdits nanoéléments pour modifier ses caractéristiques électriques,
procédé dans lequel l'étape d'introduction du mélange (6) dans une enceinte d'un réacteur et de mise à une pression inférieure à 1 bar du réacteur est une étape intermédiaire entre l'étape (E2) de formation du mélange (6) et l'étape (E3) d'obtention du produit (1), et dans lequel, après l'étape d'introduction du mélange (6) dans une enceinte d'un réacteur et de mise à une pression inférieure à 1 bar du réacteur, le réacteur est ensuite fermé.

2. Procédé selon la revendication précédente, **caractérisé en ce que** l'étape de traitement thermique appliquée au mélange (6) est réalisée à une température comprise entre 270°C et 600°C, et préférentiellement comprise entre 270°C et 450°C, sous atmosphère non oxydante.

3. Procédé selon l'une des revendications précédentes, **caractérisé en ce qu'**il comprend, au préalable de l'étape de formation (E2) du mélange (6), une étape de fourniture (E1) de la pluralité de grains (3) électriquement conducteurs associés au catalyseur (4) destiné à la croissance des nanoéléments (2),

4. Procédé selon la revendication précédente, **caractérisé en ce que** l'étape de fourniture (E1) de la pluralité de grains (3) électriquement conducteurs est telle que le catalyseur comporte une pluralité d'éléments catalyseurs (4), et au moins un grain (3) de la pluralité de grains électriquement conducteurs comprend une surface (5) sur laquelle au moins un des éléments catalyseurs (4) de la pluralité d'éléments catalyseurs est fixé, avantageusement 50% des grains de la pluralité de grains sont décorés par au moins un élément catalyseur.

5. Procédé selon l'une des revendications 1 à 4, **caractérisé en ce que** l'étape d'obtention (E3) dudit produit (1) comporte une étape de formation d'un produit intermédiaire comportant des grains (3) électriquement conducteurs, à partir desquels s'étendent lesdits nanoéléments (2), et une matrice (8) enrobant au moins en partie les grains (3) électriquement conducteurs et lesdits nanoéléments (2).

6. Procédé selon la revendication précédente, **caractérisé en ce que** l'étape d'obtention (E3) du produit (1) comporte une étape de retrait (E3-2) de la matrice (8) du produit intermédiaire mise en œuvre par une étape de lavage du produit intermédiaire.

7. Procédé selon la revendication 5 **caractérisé en ce que** l'étape d'obtention (E3) du produit (1) comporte une étape de chauffage du produit intermédiaire permettant la formation, à partir de la matrice (8), d'un revêtement (9) électriquement conducteur sur lesdits nanoéléments (2).

8. Procédé selon la revendication précédente, **caractérisé en ce que** l'étape de chauffage du produit intermédiaire est mise en œuvre par une une étape de traitement thermique additionnel dudit produit intermédiaire à une température comprise entre 600°C et 1500°C, de préférence ladite température est comprise entre 900°C et 1000°C.

9. Procédé selon l'une quelconque des revendications précédentes, **caractérisé en ce que** l'étape d'obtention (E3) du produit (1) est telle qu'au terme de ladite étape d'obtention (E3), ledit produit (1) obtenu se présente sous la forme d'une poudre munie de grains (3) électriquement conducteurs à partir desquels s'étendent les nanoéléments (2) et/ou **en ce que** l'étape d'obtention (E3) du produit (1) comporte une étape de fonctionnalisation (E3-3) des nanoéléments (2) comprenant le dépôt d'une couche fonctionnelle (10) au niveau desdits nanoéléments (2).

10. Procédé selon la revendication 3 et l'une quelconque des revendications précédentes, **caractérisé en ce qu'**il comporte une étape de réalisation (E4) de la pluralité de grains (3) électriquement conducteurs associés au catalyseur (4) comprenant les étapes suivantes :
- un placement des grains (3) de la pluralité de grains et du catalyseur (4) dans un solvant,
- un séchage permettant d'évaporer le solvant d'où il résulte l'association du catalyseur (4) avec lesdits grains (3) de la pluralité de grains électriquement conducteurs.

11. Procédé de fabrication d'une électrode, **caractérisé en ce qu'**il comporte une étape de formation de ladite électrode aprés l'obtention du produit selon l'une quelconque des revendications précédentes.

## Patentansprüche

1. Verfahren zur Herstellung eines Produkts (1), das Nanoelemente (2) umfasst, wobei das Verfahren die folgenden Schritte umfasst:
- ein Bilden (E2) eines Gemisches (6), das eine Vielzahl von elektrisch leitenden Körnern (3), einen von den Körnern (3) der Vielzahl von elektrisch leitenden Körnern verschiedenen Katalysator (4) und ein flüssiges oder in Form einer Suspension fester Partikel in einem flüssigen Lösungsmittel vorliegendes und einen Vorläufer des zum Bilden der Nanoelemente (2) bestimmten Materials umfassendes Reagens (7) umfasst, wobei die Körner (3) durch ein kohlenstoffhaltiges Material oder eine elektrisch leitende organische Verbindung oder eine elektrisch leitende metallorganische Verbindung oder ein elektrisch leitendes anorganisches Material wie eine Keramik gebildet werden und wobei das zum Bilden der Nanoelemente (2) bestimmte Material so gewählt ist, dass das Material Silicium, Germanium oder eine Legierung von Silicium mit einem der aus Germanium, Zinn, Nickel, Kupfer oder einem anderen Übergangsmetall gewählten Materialien oder eine Legierung von Germanium mit einem der aus Silicium, Zinn, Nickel, Kupfer oder einem anderen Übergangsmetall gewählten Materialien beinhaltet,
- ein Einführen des Gemisches (6) in eine Kammer eines Reaktors und ein Beaufschlagen des Reaktors mit einem Druck unter 1 bar,
- ein Schließen des Reaktors,
- ein Erhalten (E3) des Produkts (1) ausgehend von dem Gemisch (6), umfassend einen Schritt des Aufwachsens (E3-1) der Nanoelemente (2) ausgehend von dem Katalysator (4), der dann mit den Körnern (3) der Vielzahl von elektrisch leitenden Körnern kombiniert ist, wobei der Schritt des Aufwachsens (E3-1) durch einen auf das Gemisch (6) angewandten Schritt der Wärmebehandlung durchgeführt wird,
wobei das Reagens (7) eine Dotierungsstoffquelle für das zum Bilden der Nanoelemente bestimmte Material enthält, um dessen elektrische Eigenschaften zu verändern,
Verfahren, bei dem der Schritt des Einführens des Gemisches (6) in eine Kammer eines Reaktors und des Beaufschlagens des Reaktors mit einem Druck unter 1 bar ein Zwischenschritt zwischen dem Schritt (E2) des Bildens des Gemisches (6) und dem Schritt (E3) des Erhaltens des Produkts (1) ist und bei dem der Reaktor nach dem Schritt des Einführens des Gemisches (6) in eine Kammer eines Reaktors und des Beaufschlagens des Reaktors mit einem Druck unter 1 bar anschließend geschlossen wird.

2. Verfahren nach dem vorhergehenden Anspruch, **dadurch gekennzeichnet, dass** der auf das Gemisch (6) angewandte Schritt der Wärmebehandlung bei einer Temperatur zwischen 270 °C und 600 °C und bevorzugt zwischen 270 °C und 450 °C unter nicht oxidierender Atmosphäre ausgeführt wird.

3. Verfahren nach einem der vorhergehenden Ansprüche, **dadurch gekennzeichnet, dass** es vor dem Schritt des Bildens (E2) des Gemisches (6) einen Schritt des Bereitstellens (E1) der Vielzahl von elektrisch leitenden Körnern (3), die mit dem zum Aufwachsen der Nanoelemente (2) bestimmten Katalysator (4) kombiniert sind, umfasst.

4. Verfahren nach dem vorhergehenden Anspruch, **dadurch gekennzeichnet, dass** der Schritt des Bereitstellens (E1) der Vielzahl von elektrisch leitenden Körnern (3) dergestalt ist, dass der Katalysator eine Vielzahl von Katalysatorelementen (4) beinhaltet und mindestens ein Korn (3) der Vielzahl von elektrisch leitenden Körnern eine Fläche (5) umfasst, auf der mindestens eines der Katalysatorelemente (4) der Vielzahl von Katalysatorelementen fixiert ist, vorteilhafterweise 50 % der Körner der Vielzahl von Körnern mit mindestens einem Katalysatorelement dekoriert sind.

5. Verfahren nach einem der Ansprüche 1 bis 4, **dadurch gekennzeichnet, dass** der Schritt des Erhaltens (E3) des Produkts (1) einen Schritt des Bildens eines Zwischenprodukts beinhaltet, das elektrisch leitende Körner (3) beinhaltet, ausgehend von denen sich die Nanoelemente (2) erstrecken, und eine Matrix (8), welche die elektrisch leitenden Körner (3) und die Nanoelemente (2) mindestens zum Teil umhüllt.

6. Verfahren nach dem vorhergehenden Anspruch, **dadurch gekennzeichnet, dass** der Schritt des Erhaltens (E3) des Produkts (1) einen Schritt des Entfernens (E3-2) der Matrix (8) des Zwischenprodukts beinhaltet, der durch einen Schritt des Waschens des Zwischenprodukts durchgeführt wird.

7. Verfahren nach Anspruch 5, **dadurch gekennzeichnet, dass** der Schritt des Erhaltens (E3) des Produkts (1) einen Schritt des Erhitzens des Zwischenprodukts beinhaltet, der das Bilden, ausgehend von der Matrix (8), eines elektrisch leitenden Überzugs (9) auf den Nanoelementen (2) ermöglicht.

8. Verfahren nach dem vorhergehenden Anspruch, **dadurch gekennzeichnet, dass** der Schritt des Erhitzens des Zwischenprodukts durch einen zusätzlichen Schritt der Wärmebehandlung des Zwischenprodukts bei einer Temperatur zwischen 600 °C und 1500 °C durchgeführt wird, wobei die Temperatur bevorzugt zwischen 900 °C und 1000 °C beträgt.

9. Verfahren nach einem der vorhergehenden Ansprüche, **dadurch gekennzeichnet, dass** der Schritt des Erhaltens (E3) des Produkts (1) dergestalt ist, dass das erhaltene Produkt (1) nach dem Schritt des Erhaltens (E3), in Form eines Pulvers vorliegt, das mit elektrisch leitenden Körnern (3) versehen ist, ausgehend von denen sich die Nanoelemente (2) erstrecken, und/oder dass der Schritt des Erhaltens (E3) des Produkts (1) einen Schritt zur Funktionalisierung (E3-3) der Nanoelemente (2) beinhaltet, der das Abscheiden einer funktionellen Schicht (10) an den Nanoelementen (2) umfasst.

10. Verfahren nach Anspruch 3 und einem der vorhergehenden Ansprüche, **dadurch gekennzeichnet, dass** es einen Schritt des Ausführens (E4) der Vielzahl von elektrisch leitenden Körnern (3), die mit dem Katalysator (4) kombiniert sind, beinhaltet, umfassend die folgenden Schritte:
- ein Einbringen der Körner (3) der Vielzahl von Körnern und des Katalysators (4) in ein Lösungsmittel,
- ein Trocknen, das es ermöglicht, das Lösungsmittel zu verdampfen, woraus die Kombination des Katalysators (4) mit den Körnern (3) der Vielzahl von elektrisch leitenden Körnern resultiert.

11. Verfahren zur Herstellung einer Elektrode, **dadurch gekennzeichnet, dass** es einen Schritt des Bildens der Elektrode nach dem Erhalten des Produkts nach einem der vorhergehenden Ansprüche beinhaltet.

## Claims

1. A process for manufacturing a product (1) comprising nanoelements (2), said process comprising the following steps:
- forming (E2) a mixture (6) comprising a plurality of electrically conductive grains (3), a catalyst (4) separate from the grains (3) of the plurality of electrically conductive grains, and a reactant (7) that is liquid or in the form of a suspension of solid particles in a liquid solvent and comprises a precursor of the material intended to form the nanoelements (2), the grains (3) being formed by a carbon-based material or an electrically conductive organic compound or an electrically conductive organometallic compound or an electrically conductive inorganic material such as a ceramic, and the material intended to form the nanoelements (2) being chosen such that said material comprises silicon, germanium, or an alloy of silicon with one of the materials chosen from: germanium, tin, nickel, copper, or another transition metal, or an alloy of germanium with one of the materials chosen from: silicon, tin, nickel, copper, or another transition metal,
- introducing the mixture (6) into a chamber of a reactor and pressurizing the reactor to a pressure less than or equal to 1 bar,
- sealing the reactor,
- obtaining (E3) the product (1) from the mixture (6) comprising a step (E3-1) of growing said nanoelements (2) from the catalyst (4), then combined with said grains (3) of the plurality of electrically conductive grains, said growth step (E3-1) being carried out by a step of heat treatment applied to said mixture (6), the reactant (7) containing a source of dopants for the material intended to form said nanoelements to modify its electrical characteristics,
wherein the step of introducing the mixture (6) into a reactor chamber and setting the reactor to a pressure below 1 bar is an intermediate step between the step (E2) of forming the mixture (6) and the step (E3) of obtaining the product (1), and wherein, after the step of introducing the mixture (6) into a reactor chamber and setting the reactor to a pressure below 1 bar, the reactor is then sealed.

2. The process as claimed in the preceding claim, **characterized in that** the step of heat treatment applied to the mixture (6) is carried out at a temperature between 270°C and 600°C, and preferentially between 270°C and 450°C, under a non-oxidizing atmosphere.

3. The process as claimed in either of the preceding claims, **characterized in that** it comprises, prior to the step (E2) of forming the mixture (6), a step (E1) of supplying the plurality of electrically conductive grains (3) combined with the catalyst (4) that is intended for the growth of the nanoelements (2).

4. The process as claimed in the preceding claim, **characterized in that** the step (E1) of supplying the plurality of electrically conductive grains (3) is such that the catalyst comprises a plurality of catalyst elements (4), and at least one grain (3) of the plurality of electrically conductive grains comprises a surface (5) to which at least one of the catalyst elements (4) of the plurality of catalyst elements is attached, advantageously 50% of the grains of the plurality of grains are adorned with at least one catalyst element.

5. The process as claimed in one of claims 1 to 4, **characterized in that** the step (E3) of obtaining said product (1) comprises a step of forming an intermediate product comprising electrically conductive grains (3), from which said nanoelements (2) extend, and a matrix (8) at least partly covering the electrically conductive grains (3) and said nanoelements (2).

6. The process as claimed in the preceding claim, **characterized in that** the step (E3) of obtaining the product (1) comprises a step (E3-2) of removing the matrix (8) from the intermediate product carried out by a step of washing the intermediate product.

7. The process as claimed in claim 5, **characterized in that** the step (E3) of obtaining the product (1) comprises a step of heating the intermediate product that enables the formation, from the matrix (8), of an electrically conductive coating (9) on said nanoelements (2).

8. The process as claimed in the preceding claim, **characterized in that** the step of heating the intermediate product is carried out by a step of additional heat treatment of said intermediate product at a temperature between 600°C and 1500°C, preferably said temperature is between 900°C and 1000°C.

9. The process as claimed in any one of the preceding claims, **characterized in that** the step (E3) of obtaining the product (1) is such that, at the end of said obtaining step (E3), said product (1) obtained is in the form of a powder provided with electrically conductive grains (3) from which the nanoelements (2) extend and/or **in that** the step (E3) of obtaining the product (1) comprises a step (E3-3) of functionalizing the nanoelements (2) comprising the deposition of a functional layer (10) on said nanoelements (2).

10. The process as claimed in claim 3 and any one of the preceding claims, **characterized in that** it comprises a step (E4) of producing the plurality of electrically conductive grains (3) combined with the catalyst (4) comprising the following steps:
- placing the grains (3) of the plurality of grains and the catalyst (4) in a solvent,
- drying, which makes it possible to evaporate the solvent which results in the combination of the catalyst (4) with said grains (3) of the plurality of electrically conductive grains.

11. A process for manufacturing an electrode, **characterized in that** it comprises a step of forming said electrode after obtaining the product according to any one of the preceding claims.
